# EUROPEAN PATENT APPLICATION

(11) **EP 0 827 323 A1**
(43) Date of publication of application: **04.03.1998**
(21) Application number: 96202441.0
(22) Date of filing: 03.09.1996
(51) Int. Cl.: H04N 1/00, H04N 1/031, H04N 1/024

(54) **Optical read and write systems**

(71) Applicant: Ultra Silicon Technology (UK) Limited, Bradford, West Yorkshire BD7 1DP (GB)
(72) Inventor: Stevens, Robert, West Bridgford, Nottingham (GB); Cranton, Wayne Mark, Dr., Nottingham NG1 4BU, (GB); Thomas, Clive Barrington, Prof., Burton Joyce, Nottingham (GB)
(74) Representative: Wharton, Peter Robert

(57) **Abstract**

An optical read device comprises thin-film electroluminescent light sources (12) which illuminate the paper surface, reflecting the light back through co-aligned apertures (18,21) to detector elements (22), both the light sources and detector elements being defined on or supported by a common substrate, eg glass (192). Also disclosed is a multi-function opto-electronic read/write device (162) having a pixellated light source and detector array, which is capable of operating in two distinct modes - read only and write or printhead mode.

## Description

The present invention relates to improvements in the field of systems for the optical read and write of hardcopy image data, for example laser printers, facsimile machines, scanner machines, copying machines, or a combination of these products

Presently, this is performed by separate sub-systems, i.e scanner/fax heads and electrophotographic light sources respectively.

Scanner/fax heads read information (image data) from the hardcopy, and currently the read function is achieved by two commercial devices, either a single CCD chip array with line scan imaging optics or a hybrid contact image sensor array (CIS). The CIS system utilises SELFOC (™) GRIN lens arrays to provide one to one focusing. Hence the pitch between detector elements corresponds to the pitch of the optically read image. It is then necessary to fabricate a linear array of detectors, where the length of the array is at least the width of the hardcopy. This is achieved by butting CIS die, which have photodetection circuitry, end-to-end to provide a long linear array. A separate light source sub-assembly is used to illuminate the paper surface.

Electrophotographic light sources optically write to photosensitive material, i.e the drum of a laser printer. These sources are provided by either laser-polygon systems or image bar arrays. There are variants of the image bar technology, for example the LED array, the laterally emitting thin film electroluminescent (LETFEL) array, the edge-emitting bar array and LCD bar arrays. The LED array requires the butting of GaAsP LED die, and the LETFEL array by butting either matrix addressed or integrated LETFEL die (similar to the CIS array described above). The LED and LETFEL arrays form hybrid solutions, since many die are bonded onto a supporting PCB. The edge emitting and LCD arrays utilise large substrates and are considered as large area solutions, since the complete active area is defined on a single, relatively large area substrate.

The first aspect of the present invention relates to both hybrid and large area solutions described above.

According to a first aspect of the present invention there is provided an optical read device for use with hardcopy image data, the device comprising light generating means and detector means defined on and/or supported by a common substrate.

This may be achieved by defining the light generating means on the same substrate as the detector elements (for hybrid solutions and large area active devices), or by defining the light generating means on a separate substrate to the detector elements, but attaching both substrates to a common supporting substrate, eg a pcb.

Preferably, the light generating means comprises one or more pixellated light sources including associated switching elements such that the read time of the detector can be synchronised with the write time of the individual light sources. In essence, this comprises a discriminator circuit, which increases the feasible resolution by increasing the signal to noise ratio.

The device preferably includes light absorbing mask layers having co-aligned apertures.

The light generating means may be defined using AC and DC electroluminescent (EL) powder technology, or AC and DC thin film (TF) EL technology, and may incorporate microstructures and/or microlenses such as those described in the Applicants own co-pending UK Patent Application Number 9506336.8. That application describes the incorporation of micro-structures, particularly in the form of micro-mirrors and micro-grooves, within the active light generating medium, to enhance the useful emission, as well as the fabrication of microlenses directly above, adjacent or below each emitting area. Thus, in the present application, micro-lenses may be defined with the light generating means, as well as micro-mirrors and/or micro-grooves to enhance resolution and maximise light power coupling efficiency through either the mask apertures, or using conventional GRIN lens arrays. These micro-lenses may be either incorporated into the supporting pcb by means of ion diffusion, diffusion, or ion implantation, or may be moulded plastic, thin film lenses deposited onto the opposite surfaces of the glass pcb. These micro lenses ensure a higher coupling efficiency and reduced optical cross talk between pixel registration areas. These lenses may, if required, be shaped specifically to tailor the focusing characteristics, in particular the focal length, to the physical arrangements of the machine in which the device is to be used.

The light source may be provided by the reflected lateral, lateral emission or surface emission (or any combination of these three forms of emission) from the previously mentioned electroluminescent devices.

In some of the illustrated embodiments, the GRIN lens array may be eliminated because the light source is immediately adjacent to the paper surface and the optical power at the paper surface is high enough to remove the need for the GRIN lens, this being effectively replaced by co-aligned holes in the two light absorbing mask layers. If desired, fibre lenses having specially shaped cross sections to give focusing or collimating effects, may be used to couple the light from the source to the paper surface.

Preferably, amorphous Silicon or Polysilicon thin film detector arrays can be fabricated onto the upper surface of the glass pcb. Alignment would be ensured by utilising photolithographic techniques.

For silicon substrates the integrated electronics for the light source and detector arrays would be formed by either NMOS, PMOS, CMOS, or DMOS transistor technologies. For glass substrates the integrated electronics for the thin film light source and detector arrays would be formed by thin film transistor technologies and associated passive components.

Conveniently, the need for a PCB board for the present CIS array is removed by defining the conductive tracking on the glass PCB. This tracking and bondpad definition would facilitate flip-chip bonding of the CIS die. Present flip-chip technology has alignment tolerances of the orders of several microns, hence suitable for linear array fabrication and alignment to the co-aligned holes.

Preferably, high resolution sensors are realised by staggering the array of apertures and correcting the image data in hardware or software.

Colour scanner systems can be manufactured by utilising a "white light" emitting electroluminescent device structure. (White light is defined as containing wavelength in the red, green and blue parts of the visible spectrum).

Narrow band-pass colour filters (Red, Green and Blue) are deposited onto either the glass pcb or onto the integrated die.

Three lines of detector die are utilised for 3 colour reading. This arrangement would require that for each aperture on the lower surface of the sensor array there is an associated aperture on the upper surface.

A single line of integrated die are attached to the glass substrate. However, each pixel element is comprised of three detector elements, one for red, one for green and one for blue. The filtering for each element is deposited onto the integrated die or the glass substrate. For this arrangement, one aperture on the lower surface has associated with it 3 apertures on the top surface. For each aperture on the upper surface there is an associated detector element.

According to the first aspect of the present invention there is provided a data acquisition machine incorporating a read device according to the sixth paragraph hereof.

According to the first aspect of the present invention there is still further provided a method of manufacturing an optical read device for use with hardcopy image data, comprising the steps of defining light generating means and detector means either on a single, common substrate, or alternatively defining the light generating means and the detector means on two separate substrates and then supporting both on a common supporting substrate.

According to a second aspect of the present invention there is provided a multi-function opto-electronic read/write device for the read and/or write of hardcopy image data, the device comprising a single, pixellated light source, or alternatively an array of individual light sources, a light detector array and integrated interface electronics permitting the device to perform either as a read or write device.

According to the second aspect of the present invention there is further provided a combined facsimile, printer, scanner and photocopying machine incorporating the multi-function opto-electronic read/write device as described in the foregoing paragraph.

According to the second aspect of the present invention there is still further provided a method of manufacturing a multifunction opto-electronic read/write device for the read and/or write of hardcopy image data, comprising defining on a substrate a single, pixellated light source, (or alternatively an array of individual light sources), defining on the same or on a separate substrate a light detector array and providing integrated interface electronics permitting the device to perform either as a read or write device.

Ideally, the light generating medium for the light source(s) is defined on the same substrate as the elements of the detector array, and may be defined by powder or thin film EL devices electrically driven in either the dc, pulsed dc or ac modes.

Preferably, the light emitting source(s) is defined in very close proximity to the detector elements, thus facilitating the use of a compact train for focusing, i.e conventional SELFOC (™) GRIN lens arrays.

Preferably, the individual light source pixels have associated integral or external electronic switching elements, whereby individual pixels or groups of pixels can be controlled.

Preferably, there are provided co-aligned apertures in one or more light absorbing layers.

As with the read device according to the first aspect of the invention, micro-mirrors and micro-lenses as described in the aforementioned co-pending application may be incorporated, to enhance resolution and maximise light power coupling efficiency.

The types of read/write heads covered by this patent application are either hybrid or large area solutions. If the detector array is formed from silicon substrates then conventional NMOS, PMOS, CMOS or DMOS technology can provide integrated interface and drive circuitry for the light source and the detector array. If thin film detectors on glass provide the detector array then thin film transistor (TFT) technology can provide interface circuitry for the light source and the detector arrays. Alternatively a mixture of the two technologies TFT and MOS can be used if the head is a hybrid solution. The read/write head can be utilised either with or without conventional GRIN lens optics.

The read/write device according to the second aspect of the present invention therefore has two modes of operation - (1) read only mode comprising high resolution illumination of the paper surface at the imaging position, facilitated by the pixellated light source, combined with reading of the reflected light by the detector array, and (2) write or printhead mode, in which only the pixellated line of light emitters operates for the printhead function - the pixellated line of light is focused onto the photosensitive drum of an electrographic printer by either conventional GRIN lens optics and/or integrated micro-lenses, the control of the individual pixels being achieved by the integrated electronics or external driver circuitry.

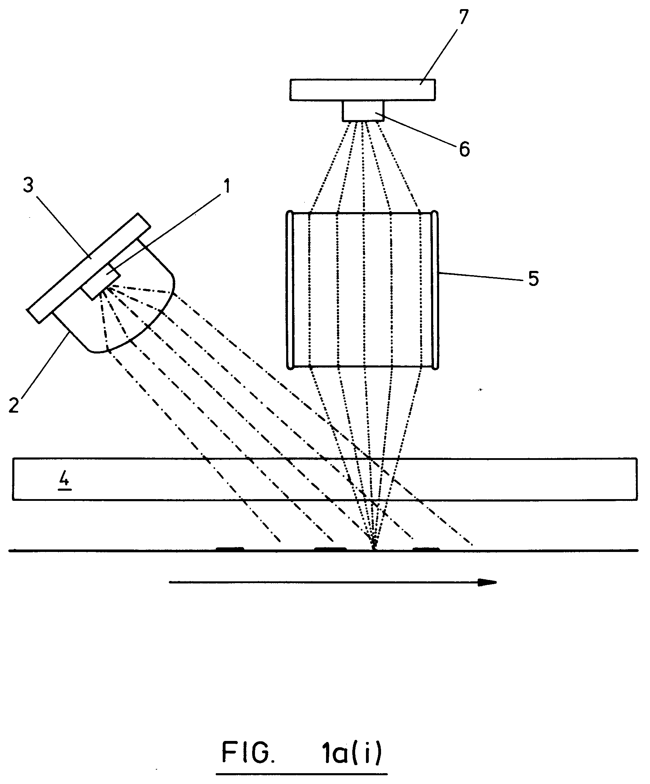

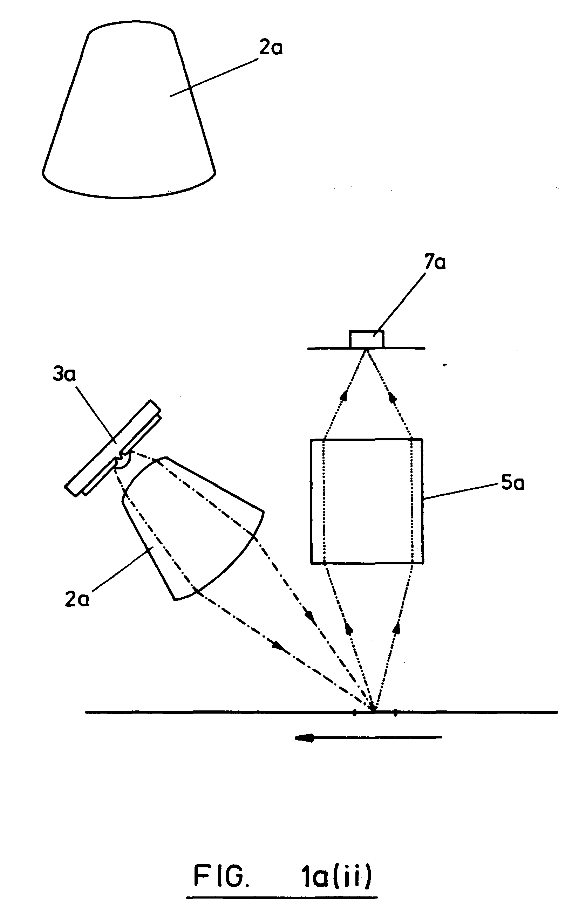

Embodiments of the present invention will now be described, by way of example only, and contrasted with the prior art, with reference to the accompanying drawings, in which:-
Figure 1a(i) is a cross section of a typical conventional CIS array,
Figure 1a(ii) is a cross section of a fibre lens included in part of an alternative light source arrangement, as shown.
Figure 1b is a cross section of a print head such as that described in Applicants' own co-pending UK patent application No 9506336.8,
Figures 2a through 2g are cross sections showing the optical read devices according to the first aspect of the invention, without conventional GRIN lens arrays,
Figures 2h through 2m are cross sections of the optical read devices according to the first aspect of the invention, utilising conventional GRIN lens arrays,
Figure 2n shows the basic imaging principle of a multi-function read/write device according to a second aspect of the present invention,
Figure 2o illustrates the principle of discriminator addressing techniques for use with the multi-function device of Figure 2n,
Figure 2p illustrates an example of the addressing sequence and expected illuminances at the hardcopy surface and the detector plane,
Figures 3a and 3b are cross sections of read devices without and with GRIN lenses respectively,
Figures 4a through 4c illustrate three different possibilities for the use of four multi-function devices to provide a full colour laser-fax, laser printer, colour scanner and colour copier,
Figure 5 illustrates the definition of absorbing masks (second step) in a process of manufacturing the read device without GRIN lenses,
Figure 6 illustrates the definition of metal tracking layers (third step),
Figure 7 illustrates an optional process step (fourth step) comprising fabricating lenses into the glass substrate,
Figure 8 illustrates capping the exposed aperture with a glass or dielectric layer (fifth step),
Figure 9 illustrates an optional sixth step of coating the micro-mirror with a reflective material,
Figure 10 illustrates two further steps (seventh and eighth steps) comprising ACTFEL deposition and post deposition processes, and definition of patterned electrodes respectively,
Figure 11 is a transverse cross-section of a LETFEL based low-resolution optical read device,
Figure 12 illustrates a variation of the device shown in Figure 11, with enhance resolution,
Figure 13 illustrates a variation of the device shown in Figure 11, being an optical read/write device,
Figure 14 illustrates a device incorporating the concepts shown in Figures 11 to 13,
Figure 15 is a longitudinal cross-section of either an optical read or optical read/write device,
Figure 16 is a plan view of an integrated photodetector array die with a single LETFEL light source,
Figure 17 is a plan view of an integrated photodetector array die with group addressed LETFEL light sources, and
Figure 18 is a plan view of an integrated photodetector array die with individually addressable LETFEL light sources.

Referring to Figure 1a of the drawings, in a typical conventional CIS array, an array of discrete LED die 1 generates divergent light which is focuses by plastic lens elements 2 to produce an illuminating linear image of uniform illuminance. The LED die 1 and plastic lenses 2 are mounted onto a PCB 3, thus forming a linear light source for illuminating the paper surface. The generated light passes through a protective glass sheet 4 and illuminates the paper at the object plane of the GRIN lens array 5. The reflected signal from the paper is higher for white areas of the hard copy, compared to toned or dark areas. Hence, reflection from small areas (pixels) of the hard copy facilitates image data acquisition, one line at a time. By moving either the CIS array or the paper a full page of information can be acquired.

The light scattered by the document surface again produces a diverging beam, which passes firstly through the protective glass plate 4 and is then coupled into the GRIN lens array 5. The lens performs a one-to-one focusing of the illuminated paper surface onto a linear array of light sensitive detectors 6. This array can be manufactured either by butting rectangular shaped, integrated silicon detector die end-to-end onto a supporting PCB 7, or by manufacturing an integrated amorphous silicon (am-Si) array or polysilicon array by thin film technology. The components 1 to 7 are assembled within a housing to form the complete CIS unit having electrical connections for supply of electrical power and input/output (I/O) signals. The signals required and generated by the integrated circuitry of all three variants form the primary interface to external hardware electronics. The function of this hardware is to perform either data storage (i.e for a scanner system) or data transmission (i.e for a fax machine).

Instead of the plastic lens elements 2, fibre lenses 2a specially profiled to have a specific cross-sectional shape, such as that shown in Figure 1a(ii), may be used to couple the light from the source (either a conventional LED source or an EL source forming part of the examples of the present invention) to the point of illumination. These fibre lenses are manufacture in accordance with known technology, being drawn from a former of the desired shape (different shapes are available), the same shape being retained in the fibre after drawings. Theses fibre lenses 2a reduce the divergence of the emergent light, either collimating or focusing the light.

Also illustrated in Figure 1a(ii) is an arrangement incorporating one of these profiled fibre lenses 2a used to focus light from a micro-mirror LETFEL device (3a) on glass or PCB on to the paper, from whence it is reflected into a GRIN or new lens array with co-aligned holes (5a), the latter focusing the beam onto a photo-detector array (7a). A TF microlens (1a) is used to couple the light from the source (3a) into the fibre lens (2a)

The present invention reduces the number of sub-assemblies required to perform the same function(s).

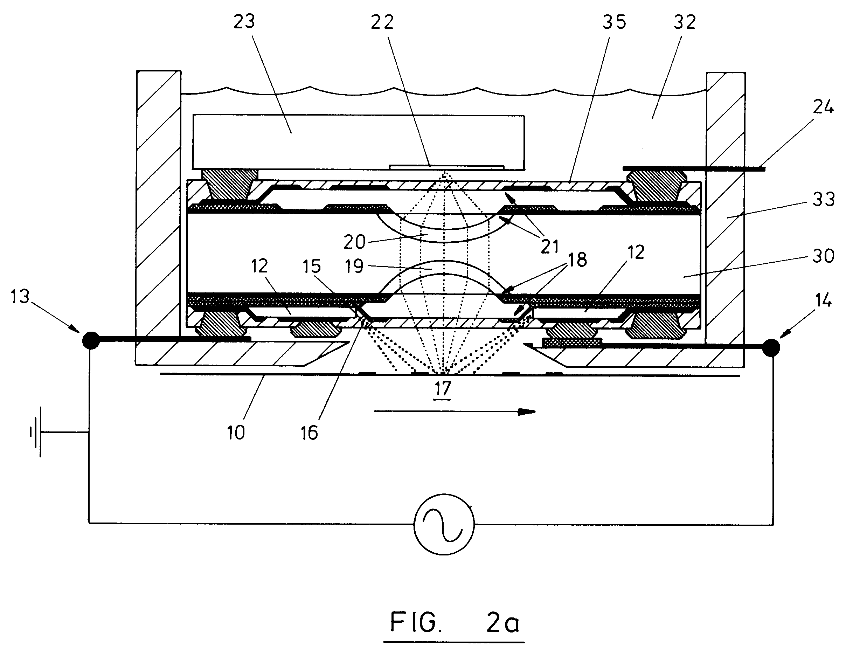

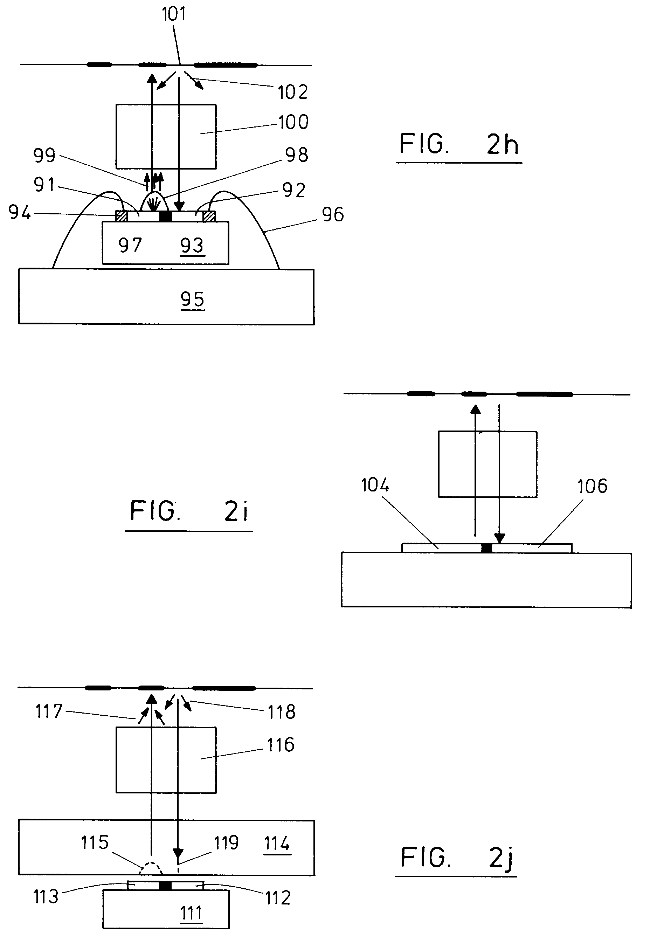

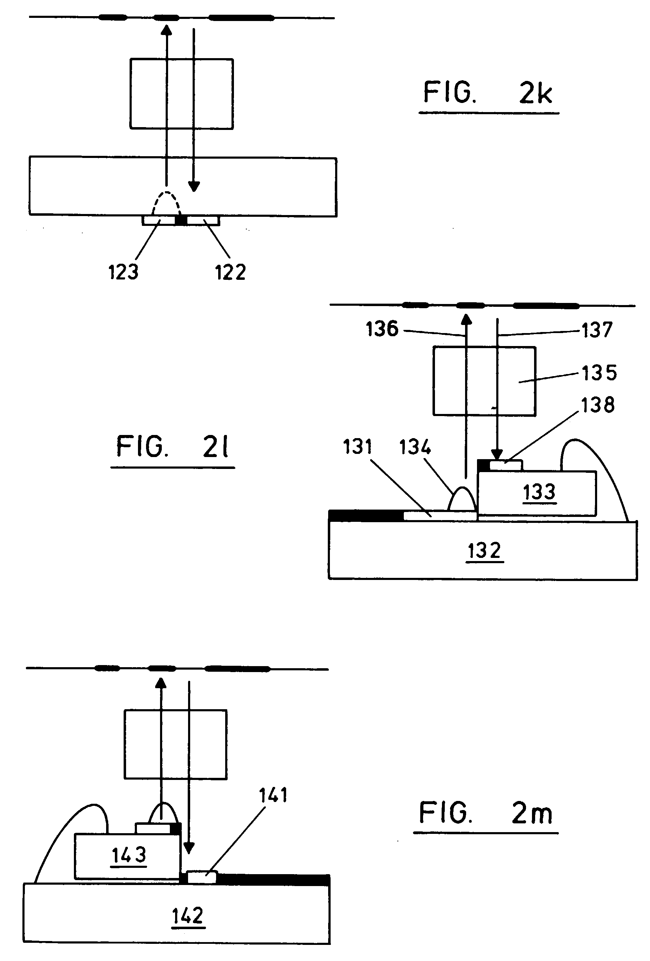

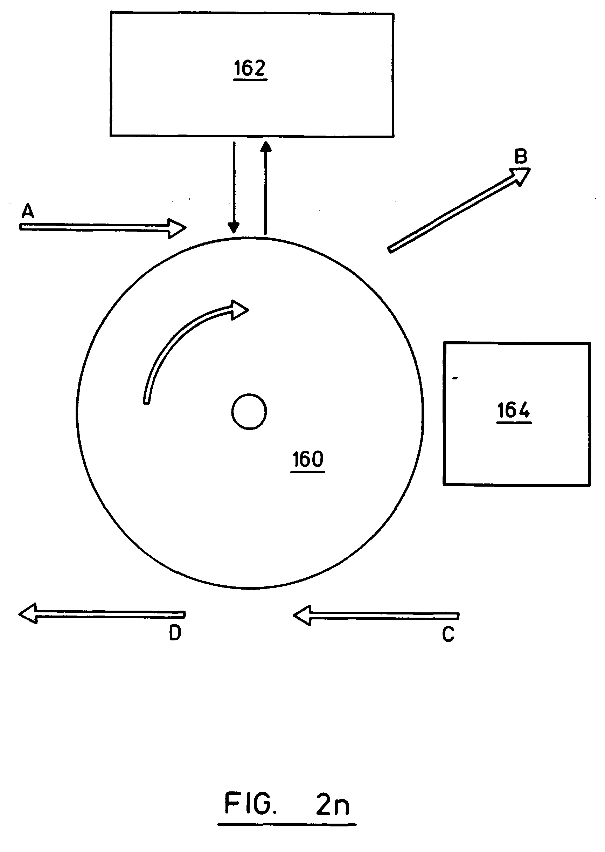

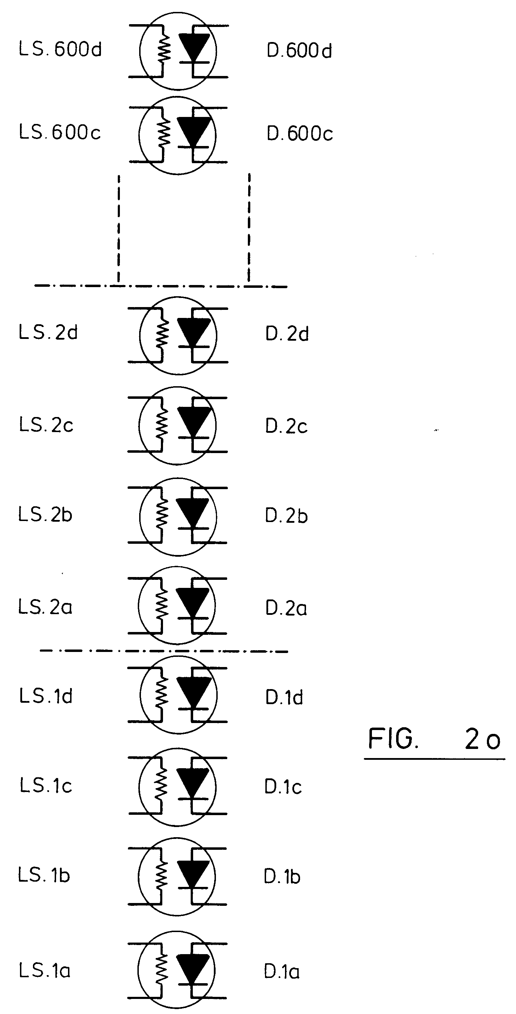

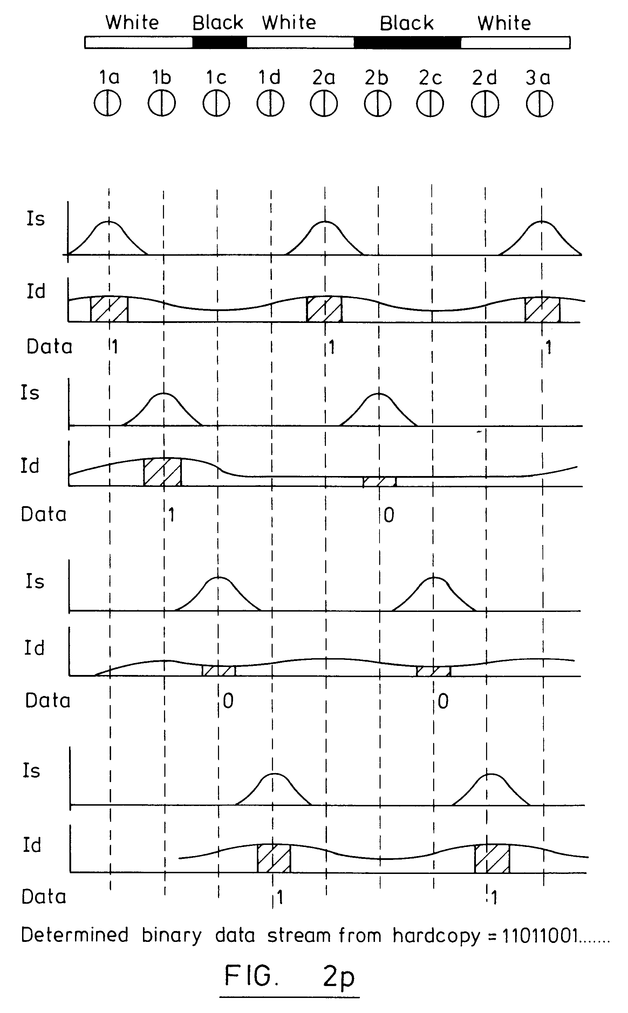

Illustrated in Figure 2a through 2g are variants of one embodiment of a read device according to the present invention, in which conventional SELFOC (™) GRIN lenses are omitted.

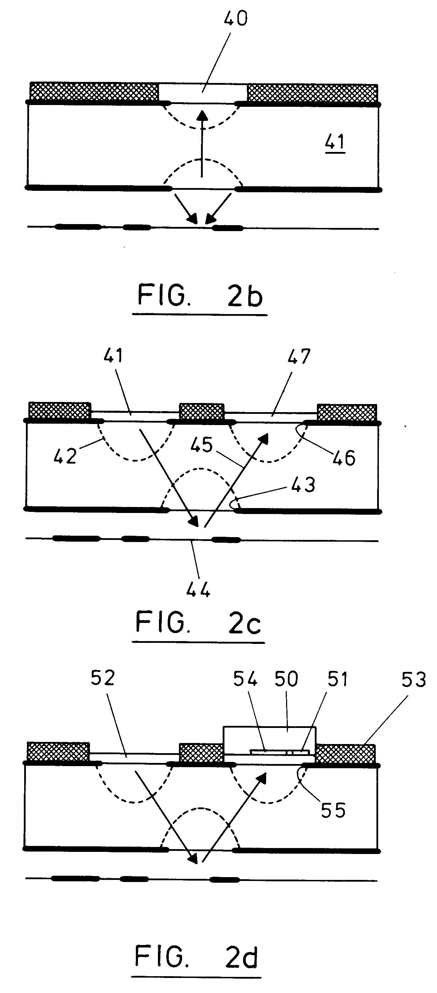

The arrangement shown in Figure 2a will be described in detail, the other close variants shown in Figures 2b through 2g will be described only briefly.

In Figure 2a, the illumination of the hardcopy (paper) surface 10 is provided by the reflected lateral emission from two AC or DC TFEL devices (12), such as those described in the Applicants' European Patent application published under no 0939937 A2 (the contents of which are incorporated herein) and/or the Applicants' co-pending UK Patent Application Number 9506336.8. High illuminance is generated by this arrangement, with good uniformity across the full array. However, the light generating medium can also be provided by EL powder technology and the light outcoupling process could be conventional surface emission, through transparent electrodes. The electrode design for the light source may be a single, common electrode, or separate groups which facilitate design of discrimination addressing methods which optimise the signal to noise and enhance possible resolution. The signal necessary for excitation of the TFEL devices is supplied by two connectors 13, 14. The signal applied to 14 should optimise device efficiency, power consumption, brightness and lifetime. The frequency (if the devices are driven in the DC, pulsed DC or AC modes) of these signals depends upon decay characteristics and the luminance required from the source. The excitation frequency can be synchronised to the read time of the detector circuitry, such that each pixel would be illuminated by similar quantities of flux. Discriminator circuitry coupled with suitable light source design facilitates better signal to noise ratio of detected data. Some of the light flux emitting from the fabricated facets 15 of the TFEL device is reflected by the micro-mirror 16 towards a localised area 17 of the paper surface. The light flux forms a linear illuminating beam, which is typically 50µm wide by 8.5 inches long with illuminance as high as 8,000 lux. A proportion of the light reflected from the illuminated paper surface couples through the masking apertures 18 of the lower surface of the glass layer 30 to the lower lens 19. This light is collimated and the nearly parallel beam couples to the lens 20 of the upper surface of the glass layer 30 . Light is guided to and through the mask apertures 21 and then falls onto one of the detector elements 22 of the CIS die 23. Image data information is acquired by the main system via I/O signal connections 24. Silicone sealant 32 seals and protects the device.

In the arrangement shown in Figure 2a, the diffused lenses 19,20 can be re-shaped to give any desired focal lengths. For example, the lens 19 could be re-defined to alter the focal length on the paper side (shown in Figure 2a as 10-100 µm) to somewhere in the region of 3-5mm, which matches the existing physical dimensions of conventional machines.

For a read only device, it is envisaged that the lenses would be shaped so as to give a short focal length (10µm - 200µm) on the detector side and a relatively long focal length (500µm - 5mm) on the paper side, in order to enable the devices to fit into existing machines.

Referring to Figure 2b, the detector and interface, designated generally by 40, are formed using thin film silicon technology on a transparent substrate 41.

The two previously described devices have the detector circuitry and the light sources defined on opposite surfaces of the transparent substrate. In the device shown in Figure 2c, both the detector 47 and light source 41 are coplanar and defined by thin film technology. Conventional surface emission and/or reflected lateral emission from an EL device 41 is guided by integrated lenses 42 towards an exposure aperture 43. Light couples to the paper surface 44 and is reflected, the reflected light 45 coupling back through the exposed aperture 43 to the detector aperture 46, where its intensity is detected by the TF detector array 47. Thin Film Transistor (TFT) interface circuitry shifts data to external electronic systems.

In Figure 2d, the detector circuitry 51 is provided by MOS technology on single crystal silicon die 50 which have been flip-chipped onto the integrated substrate 53. The detector elements 54 are aligned to the detector aperture 55. The light source 52 is exactly as shown in figure 2c.

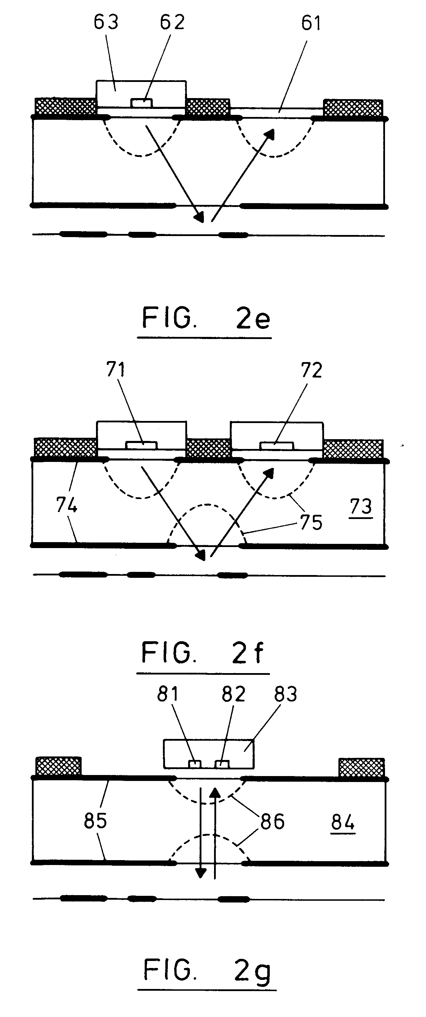

In Figure 2e, the detector circuitry 61 is provided by thin film technology and the light source 62 is defined on a separate substrate 63 (silicon or glass) which is flip-chipped onto the detector's substrate.

In Figure 2f, the light source 71 and the detector 72 are defined on separate die. These die are then flip-chip bonded onto the transparent substrate 73 with aperture layers 74 and optional lenses 75.

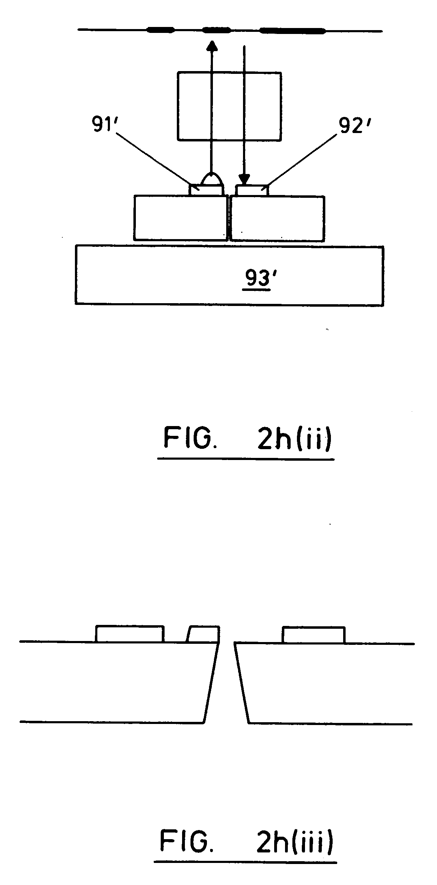

In Figure 2g, the light source 81 and the detector elements 82 are defined on the same die or substrate 83. This device is then flip-chip bonded to the transparent substrate 84 with aperture layers 85 and optional integrated lenses 86. Illustrated in Figures 2h through 2m are variants of one embodiment of a read device according to the present invention, in which GRIN lens arrays are included.

The arrangement shown in Figure 2h will be described in detail, the other close variants shown in Figures 2i through 2m will be described only briefly.

As shown in Figure 2h, the light source 91 and the detector element 92 are defined on the same single crystal die 93, where integrated MOS technology can provide the necessary interface electronics 94 to the light source and the detector elements. The die 93 are attached to a supporting substrate 95 where electrical connections are made by wirebonds 96. The diverging light emission 97 is modified by the optional integrated lens 98 to form a more collimated beam 99. This has a higher power coupling efficiency to the GRIN lens array 100. The beam is focused onto the paper surface 101 by the GRIN. The diverging reflected beam 102 couples back through the GRIN lens and part of the transmitted flux falls on the detector elements 92. Hence, hardcopy data is transferred one line at a time into electronic data for transmission or storage. The light source addressing sequence for each line may be sequential, thus providing a discriminator system to increase signal to noise and enhance possible resolution.

For greater flexibility of manufacture, the light source 91' may be defined on one die and the detector 92' on a separate die (see Figure 2h(ii)), both dies being supported on a single, common PCB 93'. The two dies are butted together end to end, leaving a gap of between 5µm to 40µm, typically approximately 20µm. The smallest size of the gap is determined by surface irregularities in the adjacent faces, and these can be avoided by undercutting each face, as shown in Figure 2h(iii), to allow even closer butting together, to the extent that for all practical purposes, the source and detector act as though they were defined on the same die, even though they are technically separate.

The cross-section shown in Figure 2i is similar to the variant shown in Figure 2h. However, the light source 104 and the detector circuits 106 are defined by thin film technology. The need for wirebonds is eliminated by this large area approach.

In Figure 2j, integrated single crystal die 111 are utilised for the detector circuitry 112 and supporting the light source 113. The die is flip-chip bonded onto a transparent substrate 114 which may have micro-lenses 115 to provide a more collimated beam to the GRIN lens 116. Light couples through the supporting substrate to the GRIN. Focusing 117, reflection 118 and detection 119 occurs as described previously.

The optical train shown in Figure 2k is similar to that shown in Figure 2j. However, the detector circuit 122 is defined by thin film silicon technology and the light source 123 is defined either by thin film or EL powder technology.

In Figure 21, a TF or powder light source 131 defined directly on the supporting substrate 132 of the Si detector die 133. Optional lenses 134 maximise power coupling efficiency to the GRIN lens array 135. Illumination of the paper surface 135 is achieved through the GRIN lens. Imaging the reflected light 137 onto the detector element 138 is achieved by the GRIN lens.

In Figure 2m, a TF detector circuit 141 is defined directly on the supporting substrate 142 of the light source die 143. The rest of the optical train is as described previously.

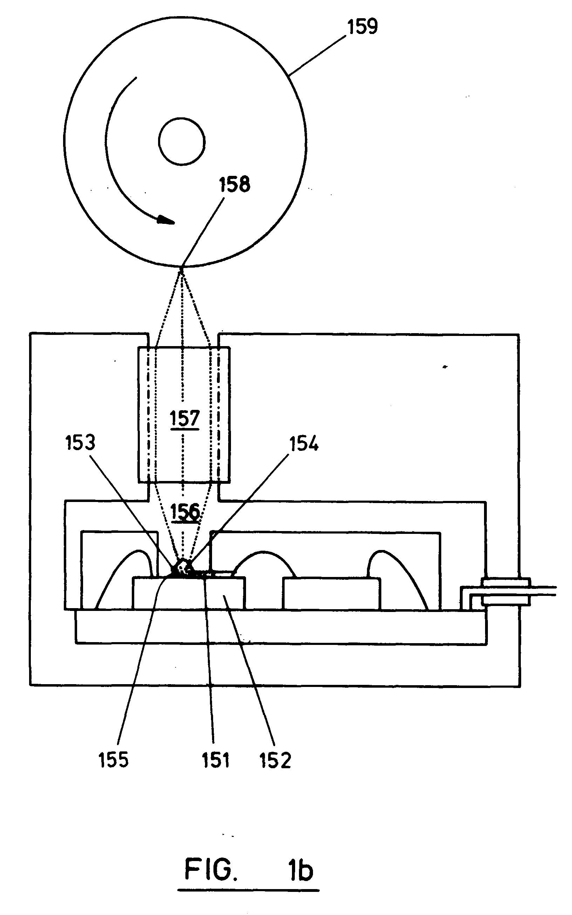

Turning now to the second aspect of the present invention, Figure 1b illustrates in cross section a typical micro-mirror LETFEL printhead incorporating both integrated micro-lenses and conventional GRIN lens optics, as described in more detail in the Applicants own co-pending UK Patent Application Number 9506336.8. In the illustrated example, the light generating medium of the micro-mirror LETFEL is provided by a pixellated ACTFEL device 151 fabricated onto a silicon substrate 152. Light propagates laterally to a micro-mirror 153 whereby lateral emission is converted into diverging surface emission. The diverging beam 154 is modified by integrated microlens elements 155 to form a more collimated beam 156 with greater power coupling efficiency to the conventional GRIN lens optics 157. The complete optical train may produce one-to-one focusing of the micro-mirror LETFEL source 158 onto the surface of the photosensitive drum 159. Pixellated line at a time optical exposure of the drum coupled with other necessary electrophotographic process provides hardcopy printing. This arrangement is to be contrasted with Figure 2n, which is a schematic of the basic imaging principle of an all on one monochrome laser-fax, laser-printer, scanner and photocopier, utilising a multifunction head according to the second aspect of the present invention.

In Figure 2n, a multi-function head 162 reads and writes optically, and the photosensitive drum 160 necessary for the electrophotograhic printing doubles as a roller of a sheet feed fax, scanner and photocopier system, thus ensuring that the hard copy is in the correct imaging (focal) position. A conventional toner unit 164 is included, and plain paper feeds in as shown by arrow C and the printed paper feeds out as shown by arrow D, whereas the hardcopy feeds in as shown by arrow A and out as shown by arrow B. A high resolution individually pixellated light source is required for the write operation, and thus the invention utilises this same source to perform the low resolution illumination for the read function, such that the head can function either as a print head or as a read device.

As previously described for the read device according to the first aspect of the invention, the multi-function device can be designed both with and without GRIN optics. For the with GRIN variants, the reader is referred back to Figures 2a to 2g, the multi-function device differing from the read device illustrated only in that the light source element has high resolution, and that each pixel can be addressed individually. TFT or MOS integration can be used for driver and addressing circuitry.

The clarity of the data collected from linear arrays of detectors and light sources from both the read devices and the multi-function devices described herein can be enhanced by utilising discriminator addressing techniques, illustrated and explained in Figure 2o where LS represents light source and D represents detector. The technique requires an individual light source for each pixel position, however they may be addressed in sequential groups, e.g a linear array of detectors at 300 dpi has 2,400 detectors in an eight inch length. If 2,400 detectors were illuminated by one eight inch light source there would be only one light source per pixel group. The same 2,400 detectors addressed by 2 light source groups, where each pixel group has 1,200 light sources. In Figure 2o there are four pixel groups identified by the suffix a, b, c and d. In an eight inch array there would be 600 light sources per pixel group. Associated with each light source is one detector. Emission from the light source is coincident with the detector read time. (The detectors read in information during the emission time of their corresponding light source). The sequence moves to the next pixel and detector group. This continues cycling until a full page is read. By having pixel groups it is possible to enhance the signal to noise ratio and the possible resolution of both the read devices and the multi-function devices of the present invention. For the read devices, the pixel groups can be defined by the electrode metallisation. However, for the multifunction array the individual addressable pixels can be driven in the required pixel group.

As shown in Figure 2p, the illumination Is at the hardcopy surface and the illumination Id at the detector plane are represented graphically in conjunction with the hard copy itself and the binary value of the detected data. From studying this figure, it is clear to see that the hard copy is converted into a suitable electronic data stream.

The present application covers any number of pixel groups, from one to an infinite number. The addressing circuitry may be integrated into the same substrate as the light source, or provided by external electronics.

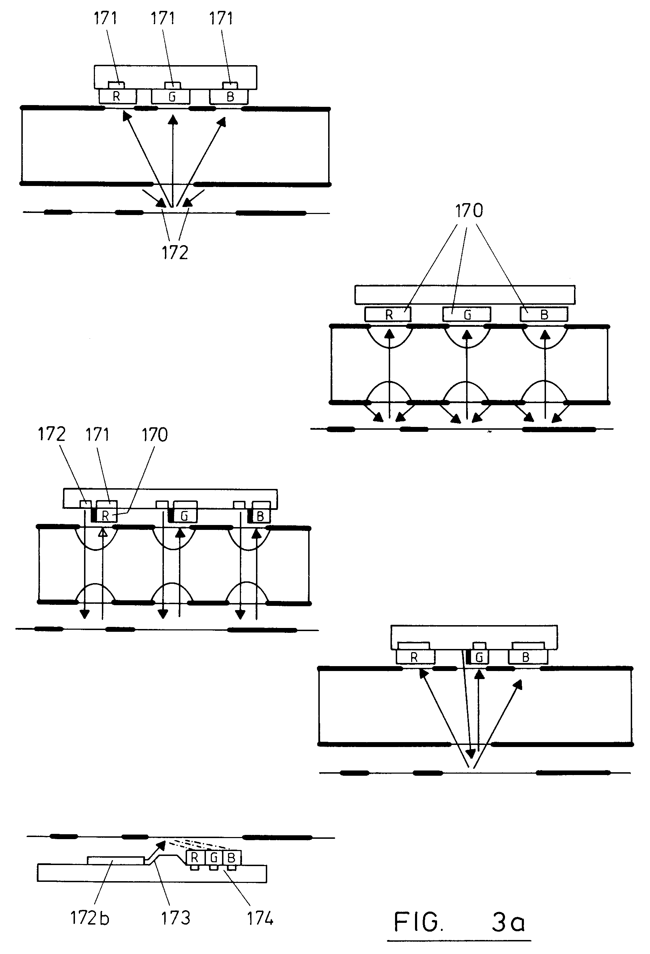

Whilst the aforementioned description relates to monochrome read and multi-function devices, future demand requires full colour scanning and printing. The read device described previously can be adapted to read colour information, as illustrated in Figures 3a (without GRIN) and 3b (with GRIN).

All of the variants shown in Figure 3a require white emitting phosphor layer as the light generating medium 172, and the use of narrow band pass coloured filters 170 (typically red (R), green (G) and blue (B)) in front of associated detectors 171. The filters 170 can be applied to the surface of the detector or formed in front of the detector window. The last variant illustrated in Figure 3a utilises a mirror 173 to reflect light from a single light source 172b at an angle onto the paper surface, from whence it is reflected back onto the detection filters to provide full-colour detection 174.

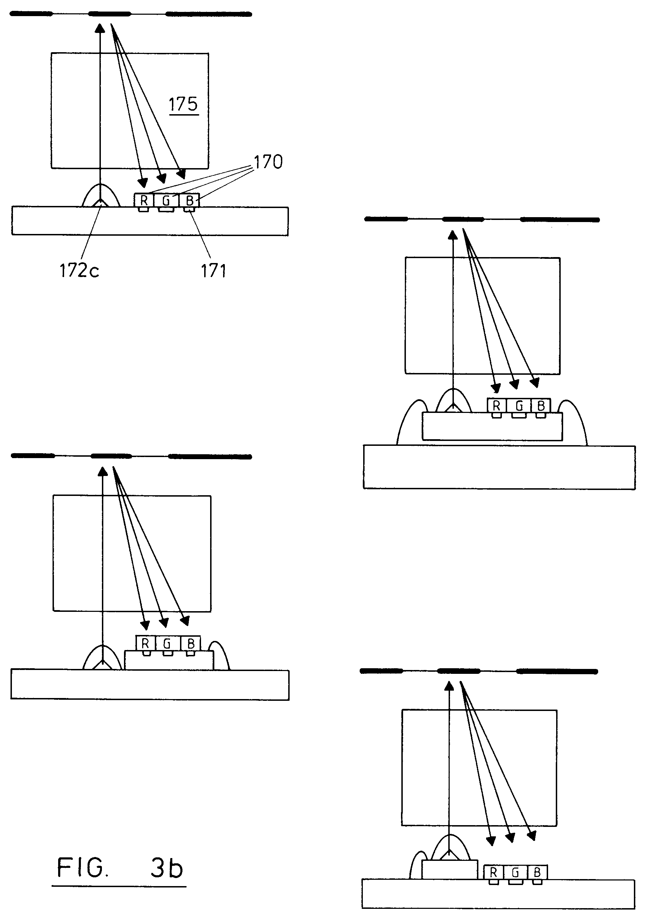

In Figure 3b, GRIN lens arrays 175 are incorporated to provide focusing.

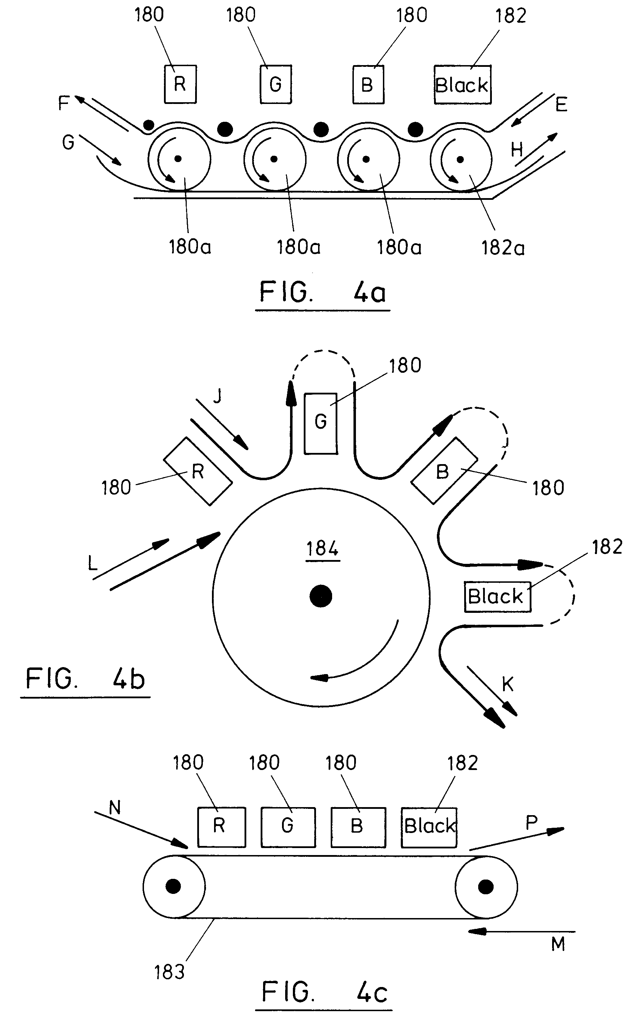

The use of four multi-functional heads in a system can provide full colour laser-fax, laser-printer, colour scanner and colour copier. A schematic of a linear system is shown in figure 4a. One head 180 each for red, one for green, one for blue and one head 182 for black and four separate photosensitive drums 180a,182a. The plain paper feeds in along arrow G and out along arrow H, whilst the hard copy feeds in along arrow E and out along arrow F.

An alternative could be to increase the size of the photosensitive drum 184 (see figure 4b) with the red, green, blue and black heads being disposed around the drum, and plain paper feeding in along arrow J, the hard copy feeding in along arrow L, and both feeding out along arrow K. A still further alternative comprises replacing the four small diameter drums with a photosensitive belt 183 as shown in figure 4c, the plain paper feeding in along arrow M with the hard copy feeding in along arrow N and out along arrow P.

Higher spatial resolution can be realised (600 dpi) by staggering the array of apertures for both hybrid and large area solutions. Correction of the read/write image data would be achieved through hardware and software.

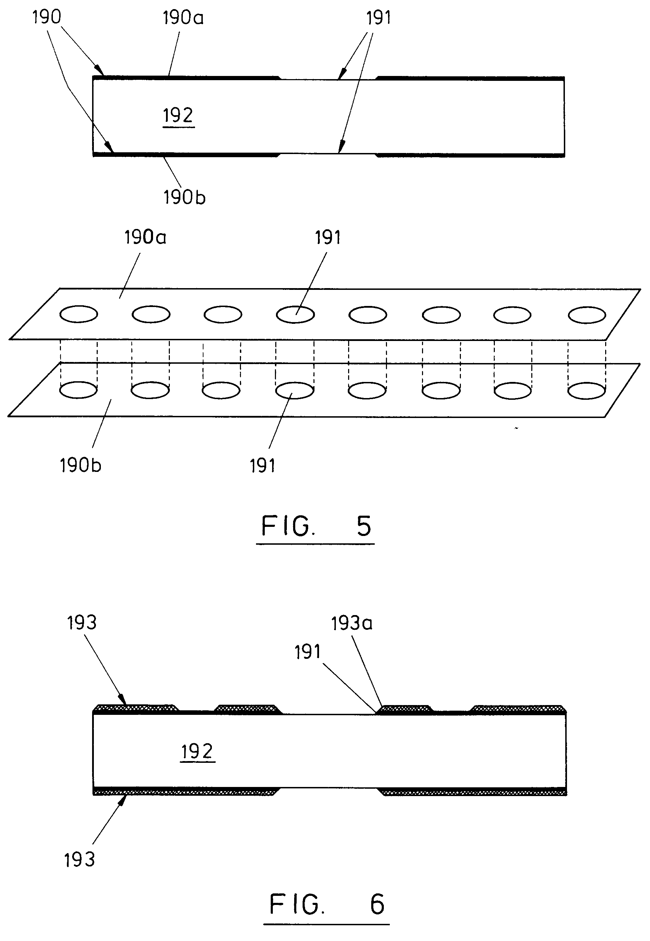

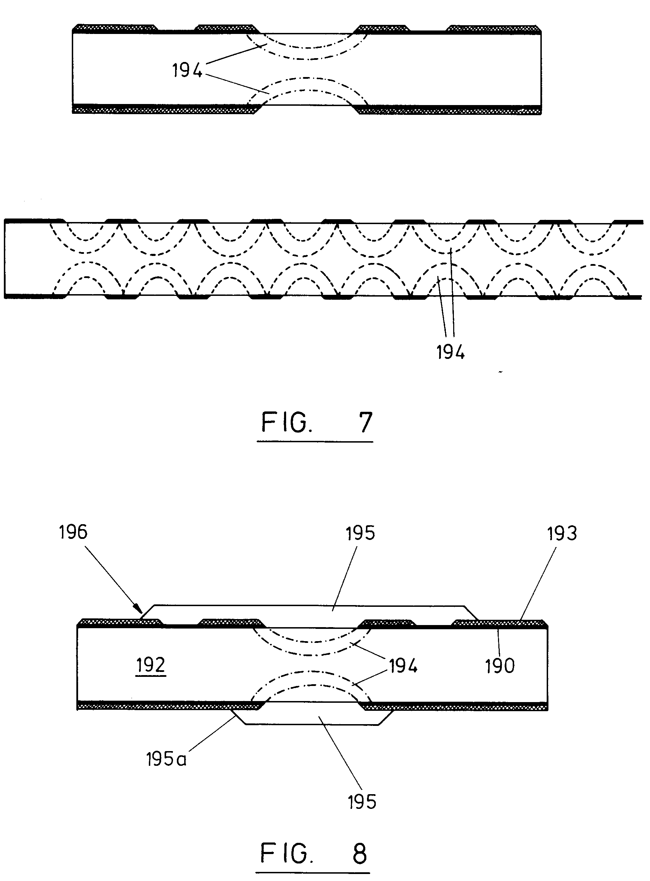

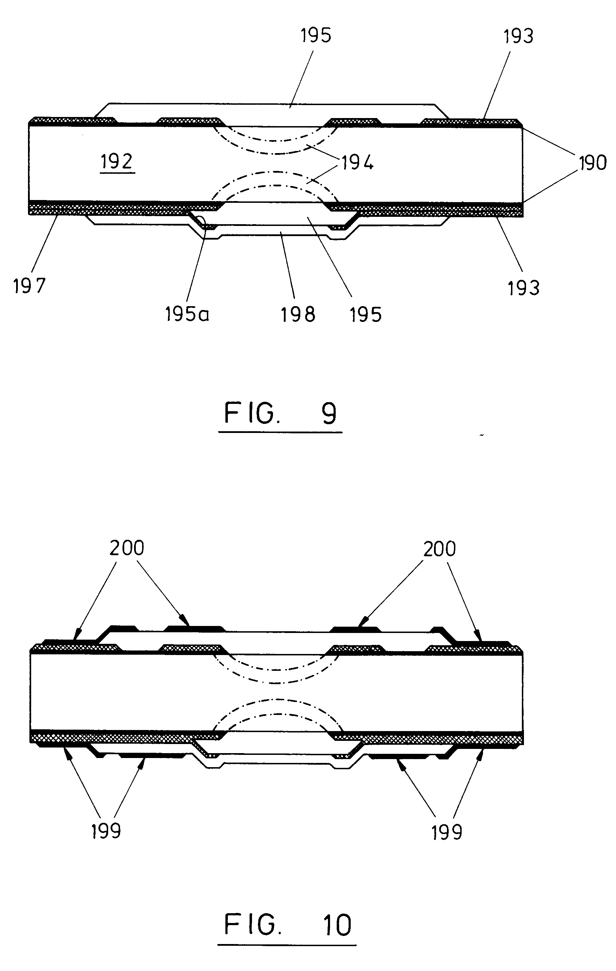

There follows a step by step description of a manufacturing process for a read device according to the first aspect of the invention (the EL-CIS without GRIN of the type illustrated in Figure 2a. The process description is illustrated in Figures 5 through 10 and the finished array is illustrated in Figure 2a.
Step 1 - Cleaning of a large area glass (transparent @ 585nm) substrates 192, e.g Corning 7059 or 7740. Although the expansion coefficient of Corning 7740 has an expansion coefficient similar to Silicon, which is important if flip-chip technology is used to attach the CIS die [Ref. S.M.Sze, Semiconductor Sensors, Page 52].
Step 2 - Definition of insulating black absorbing mask layers 190 comprising upper and lower masks 190a, 190b respectively with co-aligned holes 191. The pitch and size of the holes is dependent upon the required resolution of the sensor array. For example, a 300 dots per inch array would have a pitch between holes of approximately 85µm. However, the size of the holes (apertures) is dependent upon the sensitivity of the detector element and the illumination of the paper surface. Aperture dimensions can be as small as 10µm in diameter. Small aperture sizes may be necessary if high contrast is necessary. Cross-sectional and plan views are shown in figure 5.
Step 3 - Definition of metal tracking layers 193 on both the upper and lower surface of the substrate. The pattern again consists of a series of co-aligned holes 193a which are aligned with the co-aligned holes 191 of the black mask layers. (i.e. holes in the metal are aligned with the holes in the black mask). The layer on the upper surface forms the first metallisation layer of the tracking required to connect power and I/O signals to/from the sensor die. The patterned metal layer on the lower surface provides one of the electrodes for the post deposited alternating current thin film electroluminescent (ACTFEL) devices. Typically this would form the 0 volt electrode and ground plan. This arrangement minimises electrical noise (created by inductive coupling) in the tracking on the upper surface. Note the conductive material used for this layer must be compatible with the deposition process of ACTFEL devices, e.g. n-type polysilicon. A typical cross-sectional view of the array after this process step is shown in figure 6.
Step 4 - An optional process is to fabricate micro-lenses 194 into the glass substrate. Ion diffusion, ion-implantation or diffusion processes can be used to fabricate such lenses. Utilising these micro lenses minimises optical cross-talk between adjacent apertures. These lenses may, if required, be specifically shaped to give desired focal length characteristics, eg 10µm to 500µm on both sides. After this step it may be necessary to polish the surface, since there will be swelling of the glass lens area. Typical longitudinal and cross sections are shown in figure 7. [Ref. M Oikawa, H Nemoto, K Hamanaka, H Imanishi and T Kishimoto. Light Coupling characteristics of planar microlens, SPIE Vol 1544 Miniature and Micro-Optics: Fabrication and System Application pp 226-237 (1991) and K Nishizawa and Mashiro Oikawa, Micro-Optics Research Activities in Japan, SPIE San Diego July 1992].
   Instead of incorporating the lenses at this stage, it is possible that lens definition would be the first major process step.
Step 5 - Typically the diffusivity of the incorporated ion is high, hence it is necessary to cap the exposed aperture with a glass or dielectric layer 195. This layer is coated on both upper and lower surfaces. This capping must be transparent, e.g. SiO₂ or Si₃N₄. The capping layer on the lower surface is fabricated to form approximately 45 degree micro-mirror structures 195a, and to expose the electrode surface in the ACTFEL device and contact area. On the upper surface via holes 196 are formed and metallisation in the contact areas exposed, allowing multi-layer tracking. The capping layer 195 could be either PECVD, sputtered, or E-beam deposited or by alternative low temperature deposition techniques. In fact spin-on-glasses or polymer layers may form a satisfactory capping layer, all of these layers are etched to form shaped micro-mirrors. The cross-section of the array sensor after this process step is shown in figure 8.
Step 6 - It is an optional process to coat the micro-mirror 195a with a reflective material 197. Such coating materials must be compatible with LETFEL processing. An example of such materials are chromium, palladium, heavy doped polysilicon, molybdenum, tantalum and tungsten. Other materials such as metal silicides may prove suitable. These layers are again etched to form co-aligned holes and tracks.
Step 7 - ACTFEL deposition 198 and post deposition processes are performed to the lower side of the glass. However it must be noted that the substrate holder masks the contact areas of the substrate, thus preventing LETFEL device 198 deposition in the first metallisation electrode contact region. Possible light emission processes are either lateral, surface or a combination of lateral and surface emission. The cross-section of the array sensor after this step and step 6 is shown in figure 9.
Step 8- Patterned electrodes 199, 200 are defined on both sides of the partially integrated substrate. Note if surface emission is utilised, a transparent electrode 199 must be deposited on to the lower surface. Examples of such electrodes are Indium Tin Oxide and Zinc Oxide doped with aluminium. The electrode layer 200 on the upper surface (i.e aluminium) forms the second or third metallisation layer on the upper surface of the glass PCB. The electrode layer on the lower surface forms the high voltage electrode of the LETFEL devices. The cross-section of the array sensor after steps 7 and 8 is shown in figure 10.
Step 9 - An optional step at this stage is to fabricate emitting facets in the ACTFEL device. Dry processing should be utilised for this process. The in-contact mask would be defined by a combination of photolithography and reactive ion etching of an SiO₂ layer. Physical, and/or reactive processes etch the LETFEL materials. There is no need to remove the remaining SiO₂ mask since this assists in passivation of the device.
Step 10 - A transparent hard coating such as silicon nitride 35 is deposited onto both sides. This layer is subsequently patterned to expose the contact areas on the upper and lower surfaces.
Step 11 - If flip-chip technology is utilised, all exposed contact areas are flash plated to form "bumps". Alternatively all processes on the upper surface fabricate an amorphous silicon or polysilicon detector array with integrated thin film transistor (TFT) electronics.
Step 12 - The large glass substrate is sawn or cleaved into long thin substrates. However, prior to "breaking" the substrate could be probe tested for metallisation and dielectric integrity and the ACTFEL device quality, luminance, and uniformity. Failed devices can be marked to eliminate them from further processing steps.
Step 13 - CIS die are aligned utilising flip-chip technology, such that the centre of sensor element is on the centre line of the co-aligned holes.
Step 14 - The fully assembled array is again probe tested for sensor performance. Good devices are assembled into the housing 33 where electrical connections are made between external connectors and the contacts of the integrated sensor element. Silicone sealant 32 may be used to pot the device in the housing. The cross-section of the finished array is shown in Figure 2a.

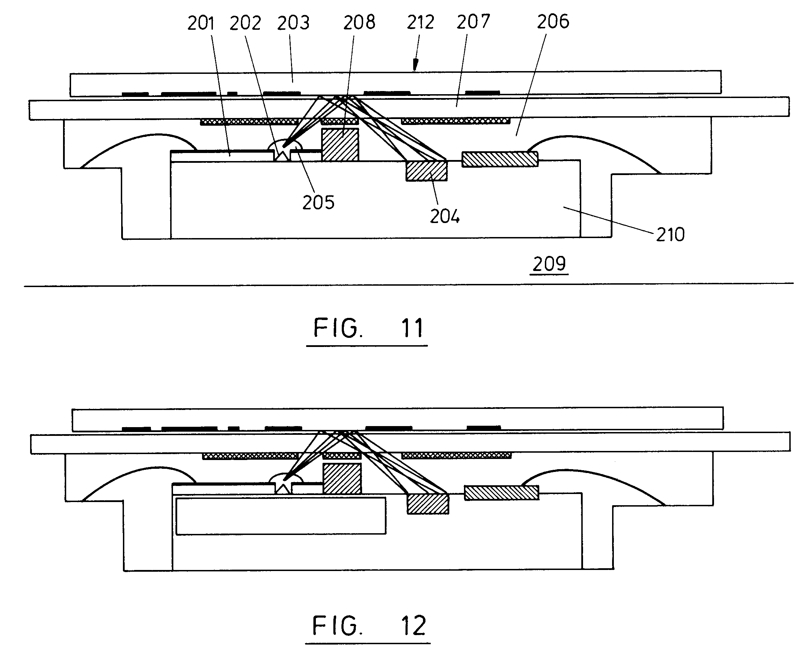

Preferred embodiments of the invention, related to the use of the device(s) in hardcopy computer products such as laser printers, facsimile machines, scanner machines, copying machines or a combination of these products, are illustrated in Figures 11 to 18, and will now be described in detail.

Figure 11 illustrates a LETFEL-based low resolution optical read device 212, in which the micro-mirror 202 is incorporated within a LETFEL 201 to provide a white light illumination source. The silicon die 210 has a pixellated array of integrated photodetectors 204 for reading the intensity of the reflected light from the paper surface 203. The individual photodetectors are coupled to integrated amplifiers and in turn to read out devices, typically shift register(s). The illumination of the paper surface is provided by the intense emission of single electrode addressed micro-mirror LETFEL device 201/202. To increase the resolution and the optical power coupled to the paper surface, appropriately shaped lens element(s) 205 can be included in the optical path between the micro-mirror source 201/202 and the paper surface 203. The lens element(s) 205 can be deposited over (in close proximity) to the micro-mirror source, diffused into the transparent cover, or are formed by free standing optical element(s) such as a fibre lens. Similarly, to maximise the optical power coupled from the illuminated paper source to the photodetector array 204, appropriately shaped lens elements can be included in the optical path between the paper surface and the photodetector sites. Electrical connection, as illustrated in Figure 11, is achieved by wirebonding from the integrated die to the housing. Alternatively, flip chip bonding achieves the electrical connection between the die and an electrically patterned protective transparent cover 206. The housing unit 209 can be a single piece or a composite component, where the unit has electrical tracking to allow connection between the integrated die and the internal/external interface and drive electronics. The protective transparent cover 206 (with or without diffused planar graded refractive index number (GRIN) microlenses) has an optional patterned light absorbing layer 207 which limits the optical cross talk between photodetectors. To prevent direct reflection from the first surface of the protective transparent cover onto the photodetectors a "light barrier rib" 208 is deposited onto the integrated die.

In Figure 12, the device configuration enables enhanced resolution of the optical read device shown in Figure 11. The higher resolution is achieved by group pixellation of the LETFEL source, which principle is illustrated in Figures 2o and 2p.

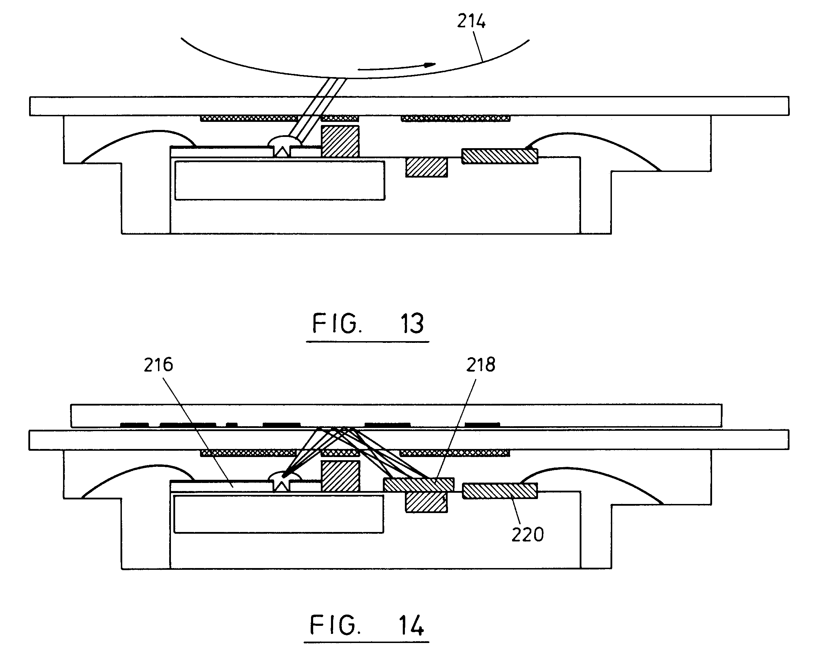

In Figure 13, the device configuration provides and optical read/write device. The write function is achieved with an electrographic print engine, where the optical read/write device provides the pixellated high resolution image bar array with approximate 1:1 imaging optics. Pixellated, individually addressable micro-mirror LETFEL array is achieved by integrating the individual LETFEL source with an electrically addressable latching element or switch, as described in the Applicants own co-pending patent application published under No GB 2294585. Lens elements provide appropriate 1:1 imaging between individual micro-mirror LETFEL light source and the photosensitive drum. Sequential strobing of the light sources allows the latent image of graphics or text to be written into the drum. The read function is achieved by feeding the hardcopy around the photosensitive drum 214, the paper surface being illuminated by selected LETFEL devices and the reflection is read by the photodetector array.

Otherwise, the various different structures making up the arrangements shown in Figures 12 and 13 are the same as those illustrated in Figure 11 and referenced as 201 to 210 inclusive.

Figure 14 illustrates a structure which incorporates the ideas within Figures 11, 12 and 13, but the illumination source is provided by a LETFEL 216 which has an emission spectrum with strong red (R), green (G) and blue (B) components. Colour filters 218 deposited over appropriate photodetector sites allow the strength of the RGB components to be determined by the photodetectors and associated read out circuitry 220. Otherwise, the various different features are the same as those shown in Figure 11 and referenced as 201 to 210 inclusive.

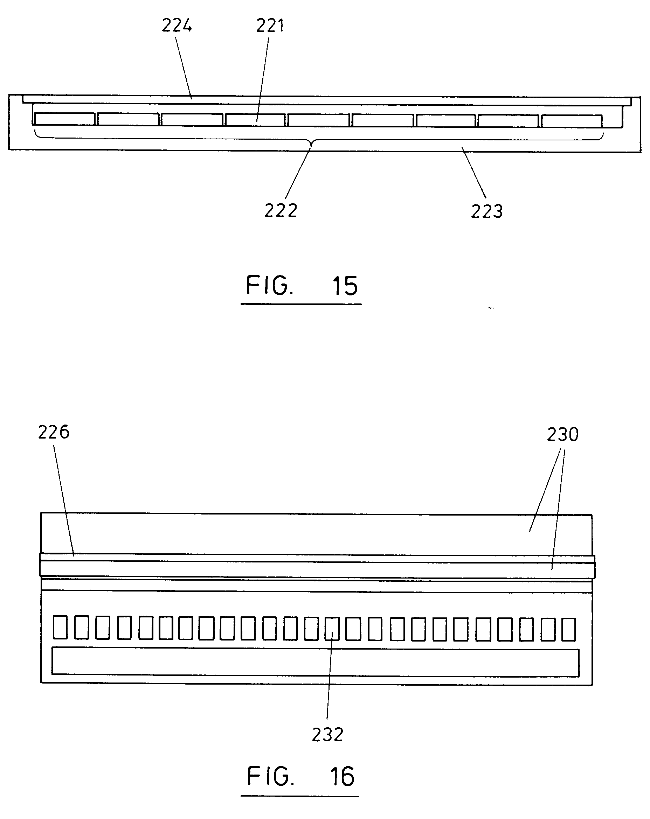

Figure 15 illustrates a longitudinal cross-section of either the optical read or optical read/write device, in which an array 222 is formed by butting the integrated photodetector die with monolithic micro-mirror LETFEL light source 221, end to end to form a bar array of the desired length. The three principle components are the housing unit 223, the protective transparent cover 224 and the integrated die 221.

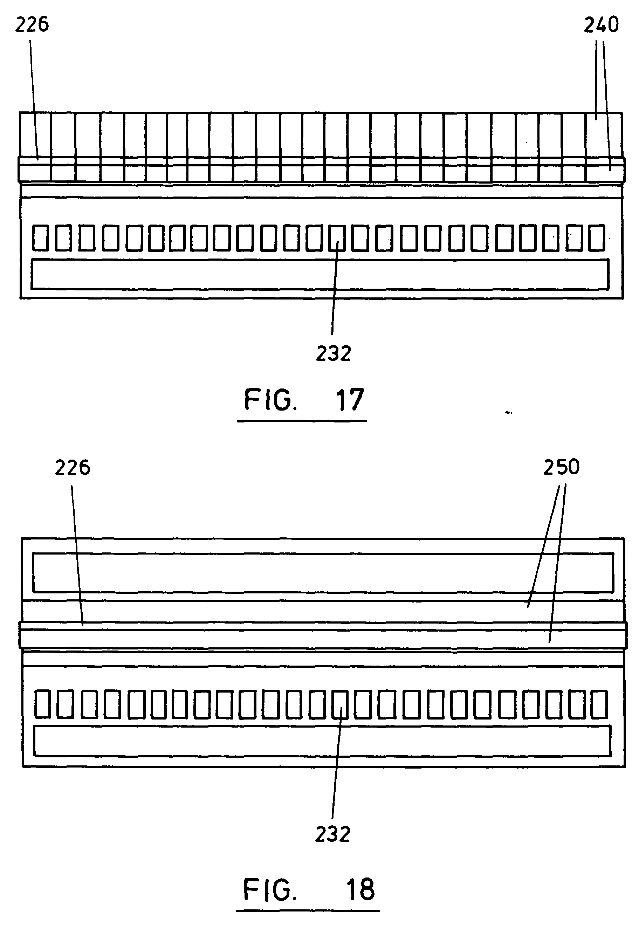

Figures 16 to 18 inclusive are plan views of an integrated photodetector arrays with single electrode, group addressed and individually addressed monolithic micro-mirror LETFEL sources, respectively. Each comprises micro-mirror with micro-lens aperture 226, photodetector sites 232, and in Figure 16 opaque single electrode 230 of the LETFEL device, in Figure 17 opaque group pixellated electrodes 240 of the LETFEL device and in Figure 18 opaque individually addressable electrodes 250 of the LETFEL device.

## Claims

1. An optical read device for use with hardcopy image data, the device including light generating means (12) for providing illumination of said hardcopy (10) and detector means (22) defined on and/or supported by a common substrate.

2. An optical read device according to Claim 1, wherein the light generating means (12) is defined on the same substrate as the detector means (22).

3. An optical read device according to Claim 1 wherein the light generating means (71) and detector means (72) are each defined on separate substrates and wherein both substrates are attached to a common supporting substrate (73).

4. An optical read device according to any of the preceding Claims, wherein the light generating means comprises one or more pixellated light sources including associated switching elements such that the read time of the detector can be synchronised with the write time of the individual light sources.

5. An optical read device according to any of the preceding Claims and including light absorbing mask layers having co-aligned apertures therein.

6. An optical read device according to any of the preceding Claims, wherein the light source is provided by the reflected lateral, lateral emission or surface emission (or any combination of these three forms of emission) from electroluminescent devices.

7. An optical read device according to any of the preceding Claims, wherein amorphous Silicon or Polysilicon thin film detector arrays are fabricated onto the upper surface of a glass or silicon pcb.

8. An optical read device according to any of the preceding claims and incorporating "white light" generating means (172) and narrow band-pass colour filters (170) in front of the detector means (171) for colour reading.

9. A data acquisition machine for use with hardcopy image data, the machine incorporating an optical read device according to any of the preceding Claims.

10. A method of manufacturing an optical read device for use with hardcopy image data, comprising the steps of defining light generating means and detector means either on a single, common substrate, or alternatively defining the light generating means and the detector means on two separate substrates and then supporting both on a common supporting substrate.

11. A multi-function opto-electronic read/write device (162) for the optical read and/or write of hardcopy image data, comprising light generating means in the form of a single, pixellated light source , or alternatively an array of individual light sources, a light detector array and integrated interface electronics permitting the device to perform either as a read or write device.

12. A combined facsimile, printer, scanner and photocopying machine incorporating the multi-function opto-electronic read/write device (162) according to Claim 11.

13. A method of manufacturing a multi-function opto-electronic read/write device, comprising defining on a substrate a single, pixellated light source, (or alternatively an array of individual light sources), defining on the same or on a separate substrate a light detector array and providing integrated interface electronics permitting the device to perform either as a read or write device.

14. A method according to Claim 13 wherein the light generating medium for the light source(s) is defined on the same substrate as the elements of the detector array.

15. A method according to Claim 13 or 14 wherein the light emitting source(s) is defined in very close proximity to the detector elements.

16. A method according to any of Claims 13 to 15 wherein individual light source pixels are provided with associated integral or external electronic switching elements, whereby individual pixels or groups of pixels can be controlled.

17. A method according to any of Claims 13 to 16 wherein there are provided co-aligned apertures in one or more light absorbing layers.

18. An opto-electronic read/write device according to Claim 11 or manufactured according to any of Claims 13 to 17 and having has two modes of operation, a read only mode comprising illumination of the paper surface at the imaging position combined with reading of the reflected light by the detector array, and a write or printhead mode, in which only the pixellated line of light emitters operates for the printhead function, the pixellated line of light being focused onto the photosensitive drum of an electrographic printer by either conventional GRIN lens optics and/or integrated micro-lenses, the control of the individual pixels being achieved by the integrated electronics or external driver circuitry.
